(19) Europäisches Patentamt

European Patent Office

Office européen des brevets

(11) **EP 4 099 026 B1**

(12) **EUROPEAN PATENT SPECIFICATION**

(45) Date of publication and mention
of the grant of the patent:
**30.04.2025  Bulletin 2025/18**

(21) Application number: **21177318.9**

(22) Date of filing: **02.06.2021**

(51) International Patent Classification (IPC):
*G01R 23/15* (2006.01)       *G01R 29/027* (2006.01)

(52) Cooperative Patent Classification (CPC):
**G01R 23/15; G01R 29/0273**

(54) **FREQUENCY MONITORING CIRCUIT AND METHOD FOR MONITORING THE FREQUENCY OF AN AC-SIGNAL**

FREQUENZÜBERWACHUNGSSCHALTUNG UND VERFAHREN ZUR FREQUENZÜBERWACHUNG EINES WECHSELSTROMSIGNALS

CIRCUIT DE SURVEILLANCE DE FRÉQUENCE ET PROCÉDÉ DE SURVEILLANCE DE LA FRÉQUENCE D'UN SIGNAL CA

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.12.2022  Bulletin 2022/49**

(73) Proprietor: **Hitachi Rail GTS Deutschland GmbH 71254 Ditzingen (DE)**

(72) Inventors:
• **KOCH, Markus**
**71254 Ditzingen (DE)**
• **LING, Dominik**
**71254 Ditzingen (DE)**

(74) Representative: **Kohler Schmid Möbus Patentanwälte Partnerschaftsgesellschaft mbB Gropiusplatz 10 70563 Stuttgart (DE)**

(56) References cited:
**EP-A2- 0 872 739     US-A- 4 667 328 US-A- 4 799 024**

## Description

Field of invention

The invention concerns a frequency monitoring circuit for monitoring an AC input signal, the circuit comprising an AC-signal input for providing the AC input signal to be monitored, a resettable circuit comprising a capacitor connected to ground, a reference power supply for charging the capacitor, and a discharge switch connected in parallel with the capacitor to control charging and discharging of the capacitor, a switch control for controlling the discharge switch, a comparator being electrically connected after the resettable circuit. The invention further concerns a method for monitoring the frequency of an AC-signal.

Background of the invention

An according frequency monitoring circuit is known from JP 2012-109836 A [01].

In many technical areas, it is important to detect whether an AC signal is within a specified range, e.g. in digital logic (Microcontroller, FPGA, ...), life signal supervision or (motor) speed supervison. Therefore, an according frequency supervision is required in order to detect that an input signal is within a specific range or to signal when the input signal does not fulfill the requirements anymore.

Analog band-pass filters, tone decoder ICs (like the LM567 [03], and fully digital approaches (Microcontroller, FPGA) are general knowledge for monitoring frequencies.

DE 4023700 C2 [02] discloses a frequency monitoring circuit for a signal sequence.of a microcomputer (watchdog). When a certain deviation from the prescribed frequency is detected, the microcomputer is reset. This is achieved by applying cyclic reset signals at the reset input of the microcomputer, when an excessive frequency error is detected.

JP 2012-109836 A [01] discloses a frequency monitoring circuit for monitoring frequency abnormities of clock signals. The circuit comprises a charging/discharging unit with two switches and two constant current sources for charging a capacitor. When the charging voltage drops to a lower limit voltage, the capacitor is switched from the discharged state to the charged state. On the other hand, when the pulse edge of the clock signal arrives, or when the charging voltage rises to the upper limit voltage the capacitor is switched from the charged state to the discharged state. When the charging voltage rises to the upper limit voltage, a reset signal RESET is lowered from the high level (normal logic level) to the low level (abnormal logic level), and vice versa. I.e. when the frequency of the clock signal is too low, the capacitor is maintained in the charged state and the charging voltage is charged. The charging voltage rises to the upper limit voltage, and the reset signal is lowered from the high level to the low level. The reset signal is maintained at a low level until the charging voltage drops to the lower limit voltage after the capacitor is switched to the discharged state.

The methods known from [01] and [02] both result in cyclic reset pulses. Yet, the above described frequency monitoring circuits can only be used for square wave input signals. The known methods cannot be used for e.g. speed supervision in safety critical systems, in particular for applications which require a static output signal, for example switching power to a separate part of the device or giving the user a visual indication of the frequency OK / not OK status. Thy cannot be used to enable or disable another part of a machine.

Another frequency monitoring circuit is known from US 4667328 A.

Objectiv of the invention

It is an objective of the invention to provide a frequency monitoring circuit that allows fast and accurate supervision of arbitrary AC signals and can be used to enable or disable another part of a machine.

Summary of the invention

This objective is achieved by a frequency monitoring circuit according to claim 1 and a method for monitoring the frequency of an AC input signal according to claim 8.

The inventive frequency monitoring circuit is adapted for monitoring arbitrary AC input signals, in particular sine signals as well as square wave signals.

The inventive circuit comprises:

an AC signal input for providing the AC input signal to be monitored,
a resettable circuit comprising

    ◦ a capacitor connected to ground

○ a reference power supply for charging the capacitor,
○ a discharge switch connected in parallel with the capacitor to control charging and discharging of the capacitor,

and a switch control for controlling the discharge switch, the switch control being electrically connected between the AC signal input and the discharge switch, wherein the switch control is adapted to detect a predetermined edge of the AC-input signal (rising or falling). The switch control is adapted to control opening and closing of the discharge switch in dependence of a predetermined edge of the AC input signal. A comparator with at least one comparator output is electrically connected after the resettable circuit, wherein the comparator is adapted for comparing the capacitor voltage with at least one threshold limiting a predetermined allowed frequency range, and adapted for providing a comparator output signal at its comparator indicating whether the capacitor voltage complies with the threshold, a memory element comprising

○ at least one signal input connected to the comparator output for receiving the comparator output signal,

○ a signal output for outputting a constant frequency-ok-output signal as long as the input signals stays within the allowed frequency range, wherein the output signal is updated by the comparator output signal, in particular at predefined points in time.

○ a trigger input connected for triggering the memory element, wherein the trigger input is connected to the AC-source.

The **switch control** is connected between the AC-source and the discharge switch and is adapted to momentarily close (for discharging) and then open (for charging) the discharge switch if a predetermined edge of the AC input signal is detected. I.e. the reset of the capacitor is done by the discharge switch, which is adapted to cause both charging the capacitor (increasing capacitor voltage) and discharging the capacitor (decreasing capacitor voltage). Only one switch is provided for charging and discharging.

For detecting the predetermined edge, the switch control incorporates a zero-crossing detection device and/or an edge detector. The discharge switch is opened and closed only in dependence of a predetermined edge of the AC input signal. I.e. the switch state of the discharge switch depends only on the input signal and is independent of the capacitor voltage.

The inventive frequency monitoring circuit outputs a constant output signal as long as the input frequency of the AC input signal to be monitored stays within the allowed range (i.e above a lower threshold and/or below an upper threshold). This allows e.g. either attracting e.g. a relay or not, turning an indicator on / off, pulling digital circuitry into a reset state, or removing power from specific parts of the circuit. Alternating attraction and repulsion, as it is realized in the prior art, is not desired. This is realized by using an appropriate memory element, in particular a flip-flop. The memory element has a trigger input for triggering the checking of the capacitor voltage at the predefined points in time (trigger times). The memory element is adapted to store the received information and has an output for outputting the constant frequency ok signal until the check of the capacitor voltage shows that the frequency of the AC input signal is outside the allowed range. The trigger input is connected upstream to the resettable circuit to detect the predefined points in time, in particular the end of a period of the input signal.

For triggering the memory element to check the capacitor voltage the edge information for controlling/triggering the switch can be used. In this case, the connection between memory element and AC signal input can be provided between the switch control and the discharge switch (i.e. after to zero crossing/edge detection). This is in particular advantageous if no square wave signal is used. In the latter case, the memory element is triggered with the input of the discharge switch.

Alternatively, the memory element is adapted to detect a predetermined edge of the AC input signal to be monitored by itself (e.g. a D-type flip-flop). In this case the trigger input of the memory element can be connected directly to the AC-source (i.e. upstream to zero crossing detection device). This is in particular advantageous if a square wave signal is used.

The trigger times are points in time with respect to the period of the input signal and are one period of the AC input signal apart in time. The trigger times are therefore "at the end of a period" of the AC input signal. They are preferably defined by the predetermined edge used for switching the discharge switch.

It should be ensured that the memory element has enough time after being triggered to properly store the value before the capacitor is reset.

The inventive circuit enables to check whether the capacitor voltage exceeds an upper threshold without resetting the resettable circuit in dependence of the capacitor voltage.

Preferred embodiments of the invention

In a highly preferred embodiment the memory element is a latch or a flip-flop, in particular a D-type flip flop. In particular, if the output of the zero crossing detection device is used to control this circuit as well as the switch, a "latch" can be used instead of a flip-flop.

In a preferred embodiment, the memory element comprises a first signal input for receiving the comparator output signal if the capacitor voltage exceeds a first threshold and a second signal input (reset input) for receiving the comparator output signal if the capacitor voltage exceeds a second threshold. The provision of two separate inputs for non-compliance of two thresholds means that it is not necessary to distinguish at the inputs which threshold has not been complied with.

When using a comparator with only one threshold, the inventive frequency monitoring circuit can be used e.g. for speed monitoring (e.g. checking if a maximum speed is exceeded by monitoring the Tachometer output). If however the correct operation of a digital component, such as a microcontroller, should be monitored, e.g. if it generates an alternating, fixed-frequency signal during correct operation, it is advantageous if the comparator is a window comparator having an upper threshold and a lower threshold.

The reference voltage supply is adapted to charge the capacitor with a charging speed which is adapted to the largest period length that is expected. This can be realized by using a constant voltage source as reference voltage supply in combination with a resistor. When using a constant voltage source, an exponential charging curve is achieved The resistor causes the capacitor voltage to rise more slowly.

Alternatively, the reference voltage supply can be a **constant current source.** When using a constant current source, a linear charging curve is achieved. No additional resistor is required.

For checking correct operation of the inventive frequency monitoring circuit, the inventive frequency monitoring circuit comprises an input selection switch, which is adapted to switch between the input signal and a test signal. This allows a test signal to be fed to the switch control for testing the circuit. The test signal can be provided by a test signal input. The input selection switch is then adapted for alternate connection of the switch control with the AC-signal input and a test-signal input. Through the addition of the input selection switch, the correct functioning of the circuit can be tested on the fly, making it applicable in safety-critical contexts, where the inventive frequency monitoring circuit is preferably to be used, in particular for ensuring that a micro processor (and the software running on it) are still functioning correctly and putting railway field elements (signals, traction) into a safe state (off, stopped, ...).

The invention also concerns a method for monitoring the frequency of an AC input signal, the method comprising: Providing the AC input signal to be monitored; constantly charging a capacitor of a resettable circuit using a reference voltage supply resulting in a capacitor voltage; detecting the capacitor voltage and comparing the capacitor voltage with at least one predefined threshold using a comparator; detecting a predetermined edge of the AC input signal, the predetermined edge defining an end of the period of the AC input signal; and resetting the resettable circuit by discharging the capacitor at the end of the period of the AC input signal using a discharge switch. According to the invention, the discharge switch is exclusively triggered in dependence of the detected predetermined edge. If the capacitor voltage at the end of the period of the AC input signal complies with the threshold, a constant frequency ok output signal is output from a memory element. If the capacitor voltage at the end of the period of the AC input signal does not comply with the threshold, no frequency ok output signal is output from the memory element.

The constant frequency ok output signal is output continuously until the capacitor voltage does not comply with the threshold any more at the end of a period of the AC input signal.

The predetermined edge is detected by a zero crossing detection device and/or an edge detection element, which are preferably incorporated in the switch control. The predetermined edge can be e.g. the beginning of a rising or falling edge, a zero crossing of the signal amplitude (polarity change). It is associated to a specific point within the signal curve and defines "the end of the period of the AC input signal". The discharge switch is exclusively trigger by the device which is responsible for detecting the predetermined edge (zero crossing detection device and/or an edge detection element).

In case of a lower threshold, the capacitor voltage complies with the threshold, if the capacitor voltage is above the lower threshold. In case of an upper threshold, the capacitor voltage complies with the threshold, if the capacitor voltage is below the upper threshold. In case of a lower and an upper threshold, the capacitor voltage complies with the thresholds, if the capacitor voltage is between the lower and the upper threshold.

According to the invention, the switch state of the discharge switch exclusively depends on the then AC input signal, not on the capacitor voltage.

The capacitor is preferably charged according to the same charge curve after each reset of the resettable circuit. I.e. the function according to which the capacitor voltage increases is the same for each charging cycle. If a constant current source is used the charging speed can be constant. I.e. the charging speed is not switchable. This allows a simple construction of the circuit requiring less components.

The memory element preferably checks the output of the comparator at the end of the period.

It is further preferred that the charging process is only interrupted at the end of the period of the AC input signal.

I.e. the resetting of the resettable circuit depends only on the AC input signal. The capacitor is charged independent of whether the capacitor voltage complies with the threshold(s) or not.

Preferably, the charging and discharging is done via the same discharge switch. The discharge switch is opened if the predetermined edge is detected in order to charge the capacitor and the discharge switch is closed shortly when the end of the period of the AC input signal is detected.

At the end of the period, the memory element is latched, i.e. the value is applied/propagated. In a special embodiment the memory element is also latched after a timeout (period of slowest acceptable frequency) by using the reset input of the memory element. This "timeout" will reset the output signal (zero signal output) of the memory element, but will not reset the voltage across the capacitor. The memory element is only updated (from the comparator output) at end of the period or after a timeout.

In a preferred variant of the inventive method, the capacitor voltage is compared with a lower threshold and an upper threshold using a window comparator.

In a highly preferred variant, a frequency monitoring circuit as described above is used to carry out the inventive method.

The inventive frequency monitoring circuit can be advantageously used for monitoring input signals for speed monitoring (only one threshold is required) or life signal monitoring (two thresholds are required).

Accordingly, the inventive frequency monitoring circuit is preferably implemented in systems with micro-controllers where parts of the system need to be shut down if they no longer function properly.

Further advantages of the invention can be derived from the description and the drawings. The embodiments shown and described are not to be understood as a conclusive list, but rather have an exemplary character for the description of the invention.

Brief description of the drawings

Fig. 1    shows a basic embodiment of an inventive frequency monitoring circuit with a resettable circuit comprising a constant voltage source. In addition, intermediate waveforms of the AC signal within the circuit are shown.

Fig. 2    shows another basic embodiment of an inventive frequency monitoring circuit with a resettable circuit comprising a constant current source.

Fig. 3    shows an embodiment of the inventive frequency monitoring circuit with failure detection using an external test signal source.

Fig. 4    shows a third embodiment of the inventive frequency monitoring circuit with failure detection using the AC-signal input.

Fig. 5    shows the basic steps of the inventive method.

Fig. 6    shows a charge curve of the capacitor of the resettable circuit when using a constant voltage source plus a resistor, as shown in fig. 1.

Detailed description of the drawings

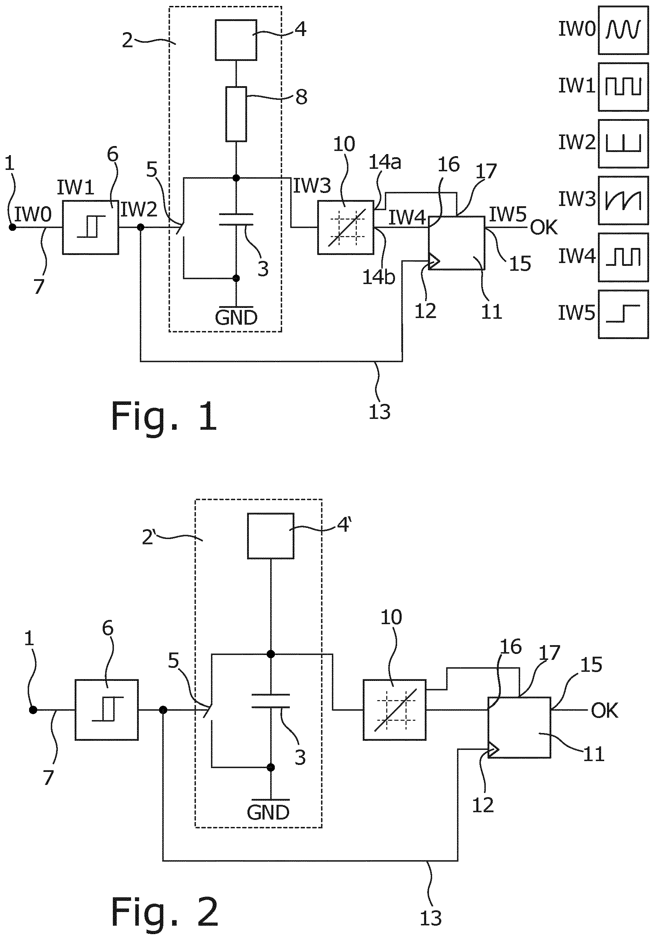

**Fig. 1** shows a block diagram of the inventive frequency supervision circuit. The frequency supervision circuit comprises an AC-signal input **1** to feed an AC input signal to be monitored (e.g. a sine signal with wave form **IW0**) into the frequency supervision circuit. The AC input signal is fed to a resettable circuit **2**. The resettable circuit 2 comprises a capacitor **3,** which is connected to ground, a reference power supply **4** for charging the capacitor 3, and a discharge switch **5** for temporarily interrupting the charging of the resettable circuit 2, by closing the discharge switch 5. When the discharge switch 5 is closed the capacitor 3 is discharged and the resettable circuit 2 is reset. Thus, the discharge switch 5 controls the reset process of the resettable circuit 2. The discharge switch 5 is connected in parallel with the capacitor 3 and is triggered/controlled by a switch control **6**. An inlet line **7** leads from the AC signal input 1 to the discharge switch 3 via the switch control 6. I.e the switch control 6 is electrically connected between the AC signal input 1 and the discharge switch 5, wherein the switch control 6 comprises a zero crossing detection device, and is adapted to control opening and closing of the discharge switch 5 in dependence of a predetermined edge of the AC input signal. The resettable circuit is adapted to constantly charge the capacitor 3 from the reference voltage supply 4. Upon seeing a rising edge on the input signal (switch input), the voltage on the capacitor 3 is reset to zero. As soon as the switch control 6 detects a rising edge of the AC input signal, the voltage at the capacitor 3 is reset to zero by temporarily closing the discharge switch 5. As a consequence, the maximum voltage across the capacitor 3 is a function of the period length of the AC input signal and therefore a function of the frequency of the AC input signal.

The resettable circuit 2 may comprise a resistor 8 connected in series with the capacitor 3 between the capacitor 3 and the reference power supply 4 as shown in Fig. 1. In this case, a constant voltage source is used as reference power supply 4.

Alternatively, the resistor 8 can be omitted by using a constant current source as reference power supply **4',** as shown in Fig. 2.

A comparator 10 is electrically connected downstream to the resettable circuit 2 for comparing the capacitor voltage with at least one threshold (upper and/or lower threshold) that limits a predetermined allowed frequency range. The comparator 10 has the function of an evaluation unit. The voltage across this capacitor is evaluated using a comparator **10,** and a memory element **11,** here: a D-type flip-flop. The memory element 11 is used to latch/store the output-signal of the comparator at predefined points in time (end of the period of the AC input signal).

When the resettable circuit is reset by closing the switch and thus discharging the capacitor, an output **14a, 14b** of the comparator is set to zero.

At the predefined points in time, immediately prior to resetting the resettable circuit 2, the memory element 11 is triggered for checking the capacitor voltage or more precisely for checking the output signal of the comparator 10 (which depends on the capacitor voltage). For triggering the memory element, the memory element 11 comprises a trigger input **12,** which is electrically connected with the inlet line 7 via a trigger line **13** for transmitting a signal, from which the end of the period of the AC input signal can be determined to the memory element 11. Thus, before the comparator output 14a, 14b is set to zero due to the reset of the resettable circuit, the comparator output 14a, 14b is checked by the memory element 11. Preferably, the end of the period is defined by a predetermined edge, in particular a zero crossing of polarity, or a falling or rising edge of the AC input signal. The memory element 11 is triggered at a defined change from either positive to negative or vice versa, but not at both. The trigger line 13 can be electrically connected directly with the AC-source 1 (i.e. upstream to the switch control 6 - not shown). In this case, the signal transmitted via the trigger line is the AC input signal itself. This is in particular advantageous if a square wave signal is used, which already has sharp edges. Such sharp edges of a signal can be used for triggering the memory element if the memory device 11 comprises an edge detector.

Alternatively, the trigger line 13 can be connected to the inlet line 7 between the zero crossing detection device of the switch control 6 and the discharge switch 5 (i.e. downstream to switch control 6 at the input to the discharge switch 5) as shown in fig. 1. The switch control is preferably adapted for detecting a predetermined edge (e.g. zero crossings) of arbitrary AC input signals, in particular of a sinus signal. The switch control 6 receives the input signal as input and generates one pulse per predefined edge (rising or falling) at its output. For an analog signal, this edge indicates a rising or falling zero crossing of the signal. In order to facilitate edge detection of non-square wave signals, the switch control 6 converts the AC input signal to sharp signal peaks. An according intermediate waveform **IW2** is shown in Fig. 1 on the right. Intermediate waveform IW2 is fed to the discharge switch 5 in order to reset the resettable circuit in case of a peak. If necessary, the intermediate waveform IW2 is generated via an intermediate step, in which first a square signal (intermediate waveform **IW1**) is generated by using the zero crossing detection device and then the intermediate waveform IW2 is generated by means of an edge detector (e.g. integrated in the zero crossing detection device or additionally provided). In case of the trigger line 13 connected downstream to the zero crossing detection device, the signal transmitted via the trigger line 13 is the first or second intermediate waveform IW1, IW2. This is in particular advantageous if no square wave signal is used as AC input signal. In the latter case, the memory element 11 is triggered with the switch input of the discharge switch 5.

The periodical resetting of the resettable circuit 2 results in a periodically charging and discharging of the capacitor 3 resulting in a third intermediate waveform **IW3** at the input of the comparator 10.

In the embodiment shown in fig. 1 the comparator 10 is a window comparator, i.e. it comprises a first signal input 16 for receiving a comparator output signal if a lower threshold is not reached at the end of the period of the AC input signal and a second input 17 (reset input) for receiving an output signal of the comparator 10 if an upper threshold is exceeded. The memory element 11 (here: flip-flop) requests a comparator output at the end of the period of the AC input signal. As long as the memory element 11 does not receive an output signal of the comparator 10 in response to the request, the memory element 11 outputs a frequency ok signal at its output 15 (frequency OK indicator of memory element 11 is activated) until a comparator output signal is detected at one of the inputs of the memory element 11. As soon as the memory element 11 receives an output signal (due to the frequency of the AC input signal exceeding the upper threshold or underrunning the lower threshold) the memory element outputs a zero signal 15 (frequency OK indicator of memory element 11 is disabled).

In contrast to the discharge switch 5, which is only reset at the end of the period of the AC input signal, the output of the memory element 11 is additionally latched asynchronously in case the comparator 10 detects that the capacitor voltage rises over the upper threshold to cover the case of a static input signal, and to give a guaranteed response time.

In the following different cases are considered:

If the frequency is **within the allowed range,** the capacitor 3 will charge until the voltage crosses the lower threshold of the window comparator 10. The next rising edge of the input signal will occur while the capacitor voltage is still within the valid area (window corresponding to the allowed frequency range of the AC input signal), propagating the frequency-ok-indication to the output of the flip-flop 11. The frequency OK indicator of the flip-flop will be activated.

If the frequency is **too high** (period too short), the capacitor 3 will start charging, but never reach the lower threshold of the window comparator 10. This causes its output to never be asserted, which leads to a '0' level being latched into the flip-flop 11 upon the rising edges of the signal input. The frequency OK indicator will stay disabled.

If the frequency is **too low** (period too long), the capacitor 3 will start charging, move through the window of the window comparator 10, but then leave the window as the voltage crosses the upper threshold. The valid signal indication will, however, not be progressed through the flip-flop 11 as it only considers its input at the rising edge of the input signal (predetermined point in time), at which point the comparator output will be '0' again. Additionally, the flip-flop 11 will be latched asynchronously as soon as the capacitor voltage rises over the upper threshold. Therefore, the frequency OK indicator will stay disabled. This behavior also covers the case that the input signal is a static level (e.g. in case the AC source is defect).

If the frequency changes from a frequency in the allowed range to a frequency that is too low, the flip-flop 11 first outputs a frequency OK signal (resulting from the capacitor voltage at the end of the period in which the frequency was in the allowed range) until the capacitor voltage rises above the upper threshold. The frequency OK indicator is disabled when the capacitor voltage rises above the upper threshold.

If the frequency changes from a frequency in the allowed range to a frequency that is too high, the flip-flop 11 will first output a frequency OK signal (resulting from the capacitor voltage at the end of the period when the frequency was in the allowed range) until the next period end of the input signal when the comparator will no longer output a signal because the capacitor voltage has not reached the lower threshold of the window comparator 10.

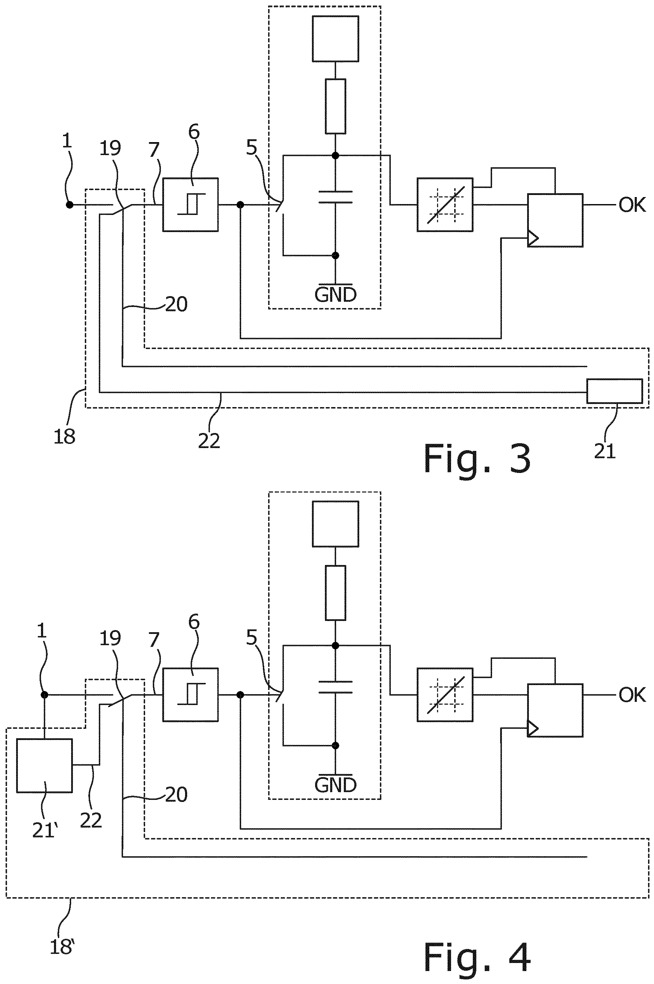

The circuits as shown in Fig. 1 and Fig. 2 do not provide any means to detect a failure of the supervision circuit itself. **Fig. 3** shows an embodiment of the inventive frequency monitoring circuit comprising a failure detection device **18.** It comprises an input selection switch **19,** which is adapted to switch between the input signal and a test signal. The input selection switch 19 can be controlled e.g. via a switch line **20.** The input selection switch 19 allows either the input signal or a test signal to be fed to the switch control 6. To test the frequency monitoring circuit, the input signal can be switched to a test signal that is out of range using the input selector switch 19. It can then be checked whether the frequency monitoring circuit detects the invalid signal or not.

The test signal can be generated by a separate test signal source **21** and can be fed to the switch control 6 via a test line **22.** The input selection switch 5 then switches between a connection of switch control 6 with the AC-signal input 1 and a connection of the switch control 6 to the test signal source 21. For this purpose, the input selection switch 19 is connected to the inlet line 7 upstream to the switch control 6, as shown in fig. 3.

Alternatively, if the test signal is generated from a source that is also controlled by the frequency monitoring system, e.g fed via the AC-signal input 1, two clock cycles of the input signal can be skipped or doubled to check the monitoring circuitry. In this case a test signal source **21'** is connected to the AC-signal input 1 as shown in fig. 4 and comprises a device for skipping or doubling the input signal. Often this change of the input signal does not affect the circuits controlled by the input signal, but is detected by the frequency monitoring circuit.

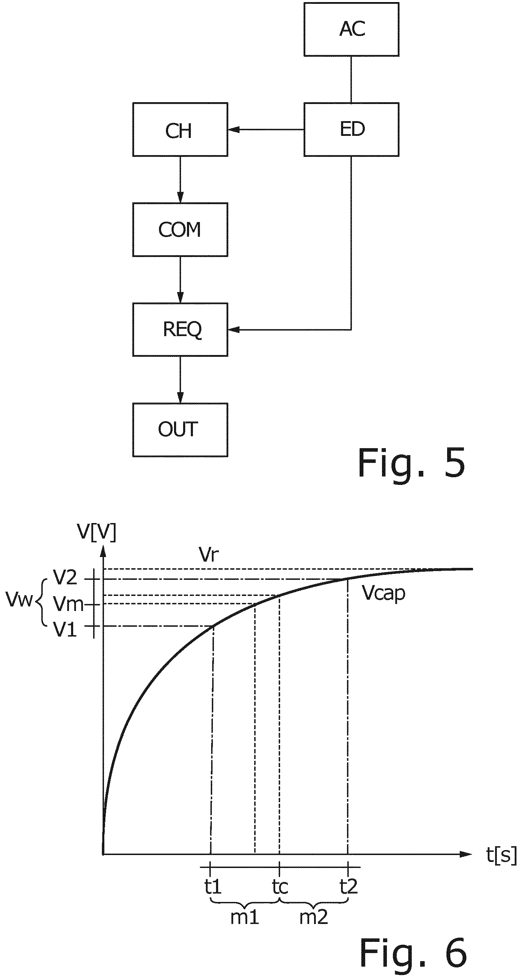

**Fig. 5** shows the basic steps of the inventive method: The AC-input signal is provided in step **AC.** In step **ED,** an edge of the AC input signal is detected (by the switch control 6 and possibly also by the memory device 11). By detection of the edge of the AC-input signal, the discharging and the subsequent constant charging of the capacitor 3 of the resettable circuit 2, 2' is triggered (step **CH).** The capacitor voltage is compared to at least one threshold in step **COM** using the comparator which outputs a comparator output signal indicating whether the capacitor voltage complies with the at least one threshold. In Addition, when the edge is detected, the memory element 11 is triggered to receive the comparator output signal (step **REQ**). In dependence of whether the comparator output signal indicates that the capacitor voltage complies with the at least one threshold, the memory element 11 outputs a signal indicating whether the frequency of the AC-input signal to be monitored is within the allowed range (step OUT). Thresholds of the comparator 11 and charging speed of the capacitor 3 are matched to each other so that they are only met when the frequency of the AC input signal is within the allowed range.

**Fig. 6** shows a diagram representing the charge curve (capacitor voltage V in dependence of charging time t) of the capacitor 3 of a special embodiment of the resettable circuit 2 comprising an RC-circuit and a constant voltage source 4 as shown in fig. 1. From fig. 6 one can see that the center frequency (or center period **tc**) of the allowed range does not necessarily correspond to the position of the center voltage **Vm** of the threshold window of the comparator 11.

Given the desired center period length tc, the lower period length margin **m1,** the upper period length margin **m2** (which together represents the allowed range), the resistance **R** of the resistor 8 and capacitance **C** of the capacitor 3 of the resettable circuit 2, the required center voltage Vm can be calculated using

$$V_m = V_1 + \frac{V_2 - V_1}{2} \qquad (1)$$

$$V_w = V_2 - V_1 \qquad (2)$$

$$t_1 = t_c - m_1 \qquad (3)$$

$$t_2 = t_c + m_2 \qquad (4)$$

$$V_{Cap}(t) = V_r \cdot \left(1 - e^{-\frac{t}{RC}}\right) \qquad (5)$$

as

$$V_m = V_r \cdot \left(\frac{2 - e^{-\frac{t_c - m_1}{RC}} - e^{-\frac{t_c + m_2}{RC}}}{2}\right) \qquad (6)$$

The required window size **Vw** of the comparator 11 can be calculated as

$$V_w = V_r \cdot \left(\frac{e^{-\frac{t_c - m_1}{RC}} - e^{-\frac{t_c + m_2}{RC}}}{2}\right) \qquad (7)$$

The required center period length tc and margins m1, m2 can be calculated from a given frequency f as

$$t(f) = \frac{1}{f} \qquad (8)$$

$$m_m(f_c, f_m) = \frac{1}{f_c} - \left(\frac{\frac{1}{f_m} - \frac{1}{f_c}}{2}\right) \qquad (9)$$

where

$f_c$ : The desired center frequency [Hz]
$f_m$: The margin towards either side [Hz]

When selecting a center voltage Vm, it is recommended to stay in the middle of the reference supply voltage of the reference voltage supply 4 for best performance. It should also be ensured that resistor 8 is able to supply the input current to the window comparator 10.

The inventive frequency supervision circuit allows fast and accurate supervision of arbitrary AC input signals. It is based on a resettable RC circuit that is reset with the frequency of the input signal. The signal output from the resettable RC circuit is evaluated using a comparator and a memory element. Its quick response time of only one input cycle is ideal for applications where an immediate reaction is required. Furthermore, the low number of high-precision components required improves the cost efficiency of the system.

List of reference signs

| 1 | AC-signal input |
| 2, 2' | resettable circuit |
| 3 | capacitor of the resettable circuit |
| 4, 4' | reference power supply |
| 5 | discharge switch |
| 6 | switch control |
| 7 | inlet line |
| 8 | resistor |
| 10 | comparator |
| 11 | memory element, in particular flip-flop |
| 12 | trigger input of memory element |
| 13 | trigger line |
| 14a, 14b | outputs of the comparator |
| 15 | output of the memory element |
| 16 | first signal input of memory element |
| 17 | second signal input (reset input) of memory element |
| 18, 18' | failure detection device |
| 19 | input selection switch |
| 20 | switch line |
| 21, 21' | test signal source |
| 22 | test line |

| tc | desired center period length [s] |
| mi | lower period length margin [s] |
| m2 | upper period length margin [s] |
| t1 | lower period length boundary [s] |
| t2 | upper period length boundary [s] |
| VT | reference voltage [V] |
| Vcap | voltage across the capacitor |
| V2 | voltage across the capacitor for the upper period length boundary [V] |
| Vm | center voltage to be set on the window comparator [V] |
| Vw | window size to be set on the window comparator [V] |

List of cited documents

[01] JP 2012 2109836 A

[02] DE 4023700 C2

[03] Texas Instruments . (2014, December). LM567 Datasheet, LM567x Tone Decoder: https://www.ti.com/lit/pdf/snosbq4

**Claims**

1.  Frequency monitoring circuit for monitoring an arbitrary AC-input signal, the circuit comprising:

- an AC signal input (1) for providing the input signal to be monitored;
- a resettable circuit (2, 2') comprising:

  ◦ a capacitor (3) connected to ground,
  ◦ a reference power supply (4, 4') for charging the capacitor (3),
  ◦ a discharge switch (5) connected in parallel with the capacitor (3) to control charging and discharging of the capacitor (3),

- a switch control (6) for controlling the discharge switch (5), the switch control (6) being electrically connected between the AC signal input (1) and the discharge switch (5), wherein the switch control (6) is adapted to detect a predetermined edge of the AC-input signal and to control opening and closing of the discharge switch (5) in dependence of the detected predetermined edge;
- a comparator (10) with at least one comparator output (14a, 14b), the comparator being electrically connected after the resettable circuit (2, 2'), wherein the comparator (10) is adapted for comparing the capacitor voltage with at least one threshold limiting a predetermined allowed frequency range, and for providing a comparator output signal at its comparator output (14a, 14b) indicating whether the capacitor voltage complies with the threshold; and
- a memory element (11) comprising:

  ◦ at least one signal input (16, 17) connected to the comparator output for receiving the comparator output signal (14a, 14b),
  ◦ a signal output (15) for outputting a constant frequency-ok-output signal as long as the input signals stays within the allowed frequency range, wherein the output signal is updated by the comparator output signal, in particular at predefined points of time, and
  ◦ a trigger input (12) connected for triggering the memory element (11), wherein the trigger input (12) is connected to the AC-input (1).

2. Frequency monitoring circuit according to claim 1, **characterized in that** the memory element (11) is a latch or a flip-flop, in particular a D-type flip flop.

3. Frequency monitoring circuit according to one of the preceding claims, **characterized in that** the memory element (11) comprises a first signal input (16) for receiving the comparator output signal if the capacitor voltage exceeds a first threshold and a second signal input (17) for receiving the comparator output signal if the capacitor voltage exceeds a second threshold.

4. Frequency monitoring circuit according to one of the preceding claims, **characterized in that** the comparator (11) is a window comparator having an upper threshold and a lower threshold.

5. Frequency monitoring circuit according to one of the claims 1 to 4, that the reference voltage supply (4) is a constant voltage source which is electrically connected to a resistor (8), wherein the capacitor (3) and the resistor (8) are connected in series.

6. Frequency monitoring circuit according to one of the claims 1 to 4, that the reference voltage supply (4') is constant current source.

7. Frequency monitoring circuit according to one of the preceding claims, that an input selection switch (19) is provided, which is adapted to switch between the input signal and a test signal.

8. Method for monitoring the frequency of an AC-input signal, the method comprising:

- Providing the AC-input signal to be monitored;
- Constantly charging a capacitor (3) of a resettable circuit (2, 2') using a reference voltage supply (4, 4') resulting in a capacitor voltage;
- Detecting the capacitor voltage and comparing the capacitor voltage with at least one predefined threshold using a comparator (10);
- Detecting a predetermined edge of the AC-input signal, the predetermined edge defining an end of the period of the AC-signal;
- Resetting the resettable circuit (2, 2') by discharging the capacitor (3) at the end of the period of the AC-input signal using a discharging switch (5);

**characterized in**

**that** the discharging switch (5) is exclusively triggered in dependence of the detected predetermined edge, and
**that** a memory element (11) comprising at least one signal input (16, 17) and a trigger input (12), wherein the at least one signal input (16, 17) is connected to the comparator output and wherein the trigger input (12) is connected to the AC-input (1) for triggering the memory element (11) to check the capacitor voltage at trigger times, wherein trigger times are points in time with respect to the period of the AC input signal and are one period of the AC input signal apart in time, and
**that** if the capacitor voltage at the end of the period of the AC-input signal complies with the threshold, a constant frequency ok output signal is output (15) from a memory element (11), and
if the capacitor voltage at the end of the period of the AC-signal does not comply with the threshold, no frequency ok output signal is output from the memory element (11).

9. Method according to claim 8, **characterized in that** the capacitor is charged according to the same charge curve after each reset of the resettable circuit.

10. Method according to claim 8 or 9, **characterized in that** the memory element checks the output of the comparator at the end of the period.

11. Method according to one of the claims 8 to 10, **characterized in that** the charging process is only interrupted at the end of each period of the input signal.

12. Method according to one of the claims 8 to 11, **characterized in that** charging and discharging is done via the same discharging switch.

13. Method according to one of the claims 8 to 12, **characterized in that** the memory element output is latched after a time out.

14. Method according to one of the claims 8 to 13, **characterized in that** the capacitor voltage is compared with a lower threshold and an upper threshold using a window comparator.

15. Method according to one of the claims 8 to 14, **characterized in that** a frequency monitoring circuit according to one of the claims 1 to 7 is used.

**Patentansprüche**

1. Frequenzüberwachungsschaltung zur Überwachung eines beliebigen Wechselstrom-Eingangssignals, wobei die Schaltung umfasst:

- einen Wechselstrom-Signaleingang (1) zur Bereitstellung des zu überwachenden Eingangssignals;
- eine rücksetzbare Schaltung (2, 2'), umfassend:

- einen Kondensator (3), der mit Masse verbunden ist,
- eine Referenzstromversorgung (4, 4') zum Laden des Kondensators (3),
- einen Entladeschalter (5), der parallel zum Kondensator (3) geschaltet ist, um das Laden und Entladen des Kondensators (3) zu steuern,
- eine Schaltersteuerung (6) zum Steuern des Entladeschalters (5), wobei die Schaltersteuerung (6) elektrisch zwischen dem Wechselstromsignaleingang (1) und dem Entladeschalter (5) geschaltet ist, wobei die Schaltersteuerung (6) dazu eingerichtet ist, eine vorbestimmte Flanke des Wechselstromeingangssignals zu erfassen und das Öffnen und Schließen des Entladeschalters (5) in Abhängigkeit von der erfassten vorbestimmten Flanke zu steuern;
- einen Komparator (10) mit mindestens einem Komparatorausgang (14a, 14b), wobei der Komparator der rücksetzbaren Schaltung (2, 2') elektrisch nachgeschaltet ist, wobei der Komparator (10) dazu eingerichtet ist, die Kondensatorspannung mit mindestens einem Schwellenwert zu vergleichen, der einen vorgegebenen zulässigen Frequenzbereich begrenzt und ein Komparatorausgangssignal an seinem Komparatorausgang (14a, 14b) bereitzustellen, das anzeigt, ob die Kondensatorspannung dem Schwellenwert entspricht; und
- ein Speicherelement (11), umfassend:

- mindestens einen Signaleingang (16, 17), der mit dem Komparatorausgang verbunden ist, um das Komparatorausgangssignal (14a, 14b) zu empfangen,
- einen Signalausgang (15) zum Ausgeben eines konstanten Frequenz-OK-Ausgangssignals, solange das Eingangssignal innerhalb des zulässigen Frequenzbereichs bleibt, wobei das Ausgangssignal durch das Komparatorausgangssignal aktualisiert wird, insbesondere zu vorgegebenen Zeitpunkten, und
- einen Triggereingang (12), der zum Triggern des Speicherelements (11) verbunden ist, wobei der Triggereingang (12) mit dem Wechselstromeingang (1) verbunden ist.

2. Frequenzüberwachungsschaltung nach Anspruch 1, **dadurch gekennzeichnet, dass** das Speicherelement (11) ein Signalspeicher oder ein Flip-Flop, insbesondere ein D-Flipflop, ist.

3. Frequenzüberwachungsschaltung nach einem der vorhergehenden Ansprüche, **dadurch gekennzeichnet, dass** das Speicherelement (11) einen ersten Signaleingang (16) zum Empfangen des Komparatorausgangssignals, wenn die Kondensatorspannung einen ersten Schwellenwert überschreitet, und einen zweiten Signaleingang (17) zum Empfangen des Komparatorausgangssignals, wenn die Kondensatorspannung einen zweiten Schwellenwert überschreitet, umfasst.

4. Frequenzüberwachungsschaltung nach einem der vorhergehenden Ansprüche, **dadurch gekennzeichnet, dass** der Komparator (11) ein Fensterkomparator mit einem oberen Schwellenwert und einem unteren Schwellenwert ist.

5. Frequenzüberwachungsschaltung nach einem der Ansprüche 1 bis 4, wobei die Referenzspannungsversorgung (4) eine Konstantspannungsquelle ist, die elektrisch mit einem Widerstand (8) verbunden ist, wobei der Kondensator (3) und der Widerstand (8) in Reihe geschaltet sind.

6. Frequenzüberwachungsschaltung gemäß einem der Ansprüche 1 bis 4, wobei die Referenzspannungsversorgung (4') eine Konstantstromquelle ist.

7. Frequenzüberwachungsschaltung nach einem der vorhergehenden Ansprüche, wobei ein Eingangsauswahlschalter (19) vorgesehen ist, welcher dazu eingerichtet ist, um zwischen dem Eingangssignal und einem Testsignal zu schalten.

8. Verfahren zur Überwachung der Frequenz eines Wechselstrom-Eingangssignals, wobei das Verfahren umfasst:

- Bereitstellen des zu überwachenden Wechselstrom-Eingangssignals;
- ständiges Laden eines Kondensators (3) einer zurücksetzbaren Schaltung (2, 2') unter Verwendung einer Referenzspannungsversorgung (4, 4'), was zu einer Kondensatorspannung führt;
- Erfassen der Kondensatorspannung und Vergleichen der Kondensatorspannung mit mindestens einem vordefinierten Schwellenwert unter Verwendung eines Komparators (10);
- Erfassen einer vorbestimmten Flanke des Wechselstrom-Eingangssignals, wobei die vorbestimmte Flanke ein Ende der Periode des Wechselstromsignals definiert;
- Zurücksetzen der zurücksetzbaren Schaltung (2, 2') durch Entladen des Kondensators (3) am Ende der Periode des Wechselstrom-Eingangssignals unter Verwendung eines Entladeschalters (5);

**dadurch gekennzeichnet, dass**

der Entladeschalter (5) ausschließlich in Abhängigkeit von der erfassten vorbestimmten Flanke ausgelöst wird, und
dass ein Speicherelement (11) mindestens einen Signaleingang (16, 17) und einen Triggereingang (12) umfasst, wobei der mindestens eine Signaleingang (16, 17) mit dem Komparatorausgang verbunden ist und wobei der Triggereingang (12) mit dem Wechselstromeingang (1) verbunden ist, um das Speicherelement (11) zu triggern, um die Kondensatorspannung zu Triggerzeiten zu überprüfen, wobei Triggerzeiten Zeitpunkte in Bezug auf die Periode des Wechselstrom-Eingangssignals sind und zeitlich eine Periode des Wechselstrom-Eingangssignals auseinander liegen, und

dass, wenn die Kondensatorspannung am Ende der Periode des Wechselstrom-Eingangssignals mit dem Schwellenwert übereinstimmt, ein konstantes Frequenz-OK-Ausgangssignal von einem Speicherelement (11) ausgegeben wird, und

wenn die Kondensatorspannung am Ende der Periode des Wechselstromsignals nicht mit dem Schwellenwert übereinstimmt, kein Frequenz-OK-Ausgangssignal von dem Speicherelement (11) ausgegeben wird.

9. Verfahren nach Anspruch 8, **dadurch gekennzeichnet, dass** der Kondensator nach jedem Zurücksetzen der rücksetzbaren Schaltung gemäß derselben Ladekurve geladen wird.

10. Verfahren nach Anspruch 8 oder 9, **dadurch gekennzeichnet, dass** das Speicherelement den Ausgang des Komparators am Ende der Periode überprüft.

11. Verfahren nach einem der Ansprüche 8 bis 10, **dadurch gekennzeichnet, dass** der Ladevorgang nur am Ende jeder Periode des Eingangssignals unterbrochen wird.

12. Verfahren nach einem der Ansprüche 8 bis 11, **dadurch gekennzeichnet, dass** das Laden und Entladen über denselben Entladeschalter erfolgt.

13. Verfahren nach einem der Ansprüche 8 bis 12, **dadurch gekennzeichnet, dass** der Ausgang des Speicherelements nach einer Zeitüberschreitung gesperrt wird.

14. Verfahren nach einem der Ansprüche 8 bis 13, **dadurch gekennzeichnet, dass** die Kondensatorspannung mit einem unteren und einem oberen Schwellwert unter Verwendung eines Fensterkomparators verglichen wird.

15. Verfahren nach einem der Ansprüche 8 bis 14, **dadurch gekennzeichnet, dass** eine Frequenzüberwachungsschaltung nach einem der Ansprüche 1 bis 7 verwendet wird.


**Revendications**

1. Circuit de surveillance de fréquence pour surveiller un signal d'entrée CA arbitraire, le circuit comprenant :

   • une entrée de signal CA (1) pour fournir le signal d'entrée à surveiller ;
   • un circuit pouvant être réinitialisé (2, 2') comprenant :

      - un condensateur (3) connecté à la terre,
      - une alimentation de référence (4, 4') pour charger le condensateur (3),
      - un commutateur de décharge (5) connecté en parallèle avec le condensateur (3) pour commander la charge et la décharge du condensateur (3),

   • une commande de commutation (6) pour commander le commutateur de décharge (5), la commande de commutation (6) étant connectée électriquement entre l'entrée de signal CA (1) et le commutateur de décharge (5), dans lequel la commande de commutation (6) est adaptée à détecter une arête prédéterminée du signal d'entrée CA et pour commander l'ouverture et la fermeture du commutateur de décharge (5) en fonction de l'arête prédéterminée détectée ;
   • un comparateur (10) avec au moins une sortie de comparateur (14a, 14b), le comparateur étant connecté électriquement après le circuit pouvant être réinitialisé (2, 2'), dans lequel le comparateur (10) est adapté à comparer la tension de condensateur avec au moins un seuil limitant une plage de fréquence autorisée prédéterminée, et à fournir un signal de sortie de comparateur au niveau de sa sortie de comparateur (14a, 14b) indiquant si la tension de condensateur est conforme au seuil ; et
   • un élément de mémoire (11) comprenant :

      - au moins une entrée de signal (16, 17) connectée à la sortie de comparateur pour recevoir le signal de sortie de comparateur (14a, 14b),
      - une sortie de signal (15) pour la sortie d'un signal de sortie ok à fréquence constante tant que les signaux d'entrée restent dans la plage de fréquence autorisée, dans lequel le signal de sortie est mis à jour par le signal de sortie de comparateur, en particulier à des moments prédéfinis, et
      - une entrée de déclenchement (12) connectée pour déclencher l'élément de mémoire (11), dans lequel l'entrée de déclenchement (12) est connectée à l'entrée CA (1).

2. Circuit de surveillance de fréquence selon la revendication 1, **caractérisé en ce que** l'élément de mémoire (11) est une bascule à verrouillage ou une bascule bistable, en particulier une bascule bistable de type D.

3. Circuit de surveillance de fréquence selon l'une des revendications précédentes, **caractérisé en ce que** l'élément de mémoire (11) comprend une première entrée de signal (16) pour recevoir le signal de sortie de comparateur si la tension de condensateur dépasse un premier seuil et une seconde entrée de signal (17) pour recevoir le signal de sortie de comparateur si la tension de condensateur dépasse un second seuil.

4. Circuit de surveillance de fréquence selon l'une des revendications précédentes, **caractérisé en ce que** le comparateur (11) est un comparateur à fenêtre ayant un seuil supérieur et un seuil inférieur.

5. Circuit de surveillance de fréquence selon l'une des revendications 1 à 4, l'alimentation en tension de référence (4) est une source de tension constante qui est connectée électriquement à une résistance (8), dans lequel le condensateur (3) et la résistance (8) sont connectés en série.

6. Circuit de surveillance de fréquence selon l'une des revendications 1 à 4, l'alimentation en tension de référence (4') est une source de courant constant.

7. Circuit de surveillance de fréquence selon l'une des revendications précédentes, un commutateur de sélection d'entrée (19) est prévu, adapté à commuter entre le signal d'entrée et un signal d'essai.

8. Procédé permettant de surveiller la fréquence d'un signal d'entrée CA, le procédé comprenant :

    • la fourniture du signal d'entrée CA à surveiller ;
    • la charge constante d'un condensateur (3) d'un circuit pouvant être réinitialisé (2, 2') à l'aide d'une alimentation en tension de référence (4, 4') résultant en une tension de condensateur ;
    • la détection de la tension de condensateur et la comparaison de la tension de condensateur avec au moins un seuil prédéfini à l'aide d'un comparateur (10) ;
    • la détection d'une arête prédéterminée du signal d'entrée CA, l'arête prédéterminée définissant la fin de la période du signal CA ;
    • la réinitialisation du circuit pouvant être réinitialisé (2, 2') en déchargeant le condensateur (3) à la fin de la période du signal d'entrée CA à l'aide d'un commutateur de décharge (5) ;

    **caractérisé en ce que**

    le commutateur de décharge (5) est exclusivement déclenché en fonction de l'arête prédéterminée détectée, et **en ce qu'**un élément de mémoire (11) comprenant au moins une entrée de signal (16, 17) et une entrée de déclenchement (12), dans lequel l'au moins une entrée de signal (16, 17) est connectée à la sortie de comparateur et dans lequel l'entrée de déclenchement (12) est connectée à l'entrée CA (1) pour déclencher l'élément de mémoire (11) afin de vérifier la tension de condensateur à des moments de déclenchement, dans lequel des moments de déclenchement sont des points dans le temps par rapport à la période du signal d'entrée CA et sont espacés dans le temps d'une période du signal d'entrée en CA, et **en ce que,** si la tension de condensateur à la fin de la période du signal d'entrée CA est conforme au seuil, un signal de sortie ok à fréquence constante est émis (15) à partir d'un élément de mémoire (11), et si la tension de condensateur à la fin de la période du signal CA n'est pas conforme au seuil, aucun signal de sortie à fréquence ok n'est émis à partir de l'élément de mémoire (11).

9. Procédé selon la revendication 8, **caractérisé en ce que** le condensateur est chargé selon la même courbe de charge après chaque réinitialisation du circuit pouvant être réinitialisé.

10. Procédé selon la revendication 8 ou 9, **caractérisé en ce que** l'élément de mémoire vérifie la sortie du comparateur à la fin de la période.

11. Procédé selon l'une des revendications 8 à 10, **caractérisé en ce que** le processus de charge n'est interrompu qu'à la fin de chaque période du signal d'entrée.

**12.** Procédé selon l'une des revendications 8 à 11, **caractérisé en ce que** la charge et la décharge sont effectuées par l'intermédiaire du même commutateur de décharge.

**13.** Procédé selon l'une des revendications 8 à 12, **caractérisé en ce que** la sortie d'élément de mémoire est basculée par verrouillage après un temps mort.

**14.** Procédé selon l'une des revendications 8 à 13, **caractérisé en ce que** la tension de condensateur est comparée à un seuil inférieur et à un seuil supérieur à l'aide d'un comparateur à fenêtre.

**15.** Procédé selon l'une des revendications 8 à 14, **caractérisé en ce qu'**un circuit de surveillance de fréquence selon l'une des revendications 1 à 7 est utilisé.

Fig. 1

Fig. 2

**Fig. 3**

**Fig. 4**

Fig. 5

Fig. 6

**EP 4 099 026 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2012109836 A
- DE 4023700 C2
- US 4667328 A
- JP 20122109836 A

### Non-patent literature cited in the description

- LM567 Datasheet, LM567x Tone Decoder. *Texas Instruments*, December 2014, https://www.ti.com/-lit/pdf/snosbq4